# EUROPEAN PATENT APPLICATION

(11) **EP 3 324 537 A1**
(43) Date of publication of application: **23.05.2018**
(21) Application number: 16824161.0
(22) Date of filing: 02.06.2016
(51) Int. Cl.: H02P 29/024, B61F 5/24, H02J 1/00, H02K 33/04

(54) **ACTUATOR CONTROL DEVICE AND ACTUATOR UNIT**

(30) Priority: 15.07.2015 JP 2015140969
(71) Applicant: KYB Corporation, Tokyo 105-6111 (JP)
(72) Inventor: OGAWA, Takayuki, Tokyo 105-6111 (JP)
(74) Representative: MFG Patentanwälte Meyer-Wildhagen Meggle-Freund Gerhard PartG mbB
(86) International application number: PCT/JP2016/066379
(87) International publication number: WO 2017/010181

(57) **Abstract**

To provide an actuator control device and an actuator unit capable of returning to control of the actuator even when a power failure occurs.

An actuator control device (C) of the present invention includes: a voltage sensor (40) that detects a voltage input to a drive circuit (D) that controls a motor (15) for driving an actuator (A), and a controller (41) that stops the motor (15) when the voltage detected by the voltage sensor (40) is equal to or less than a predetermined voltage threshold.

## Description

### Technical Field

The present invention relates to an actuator control device and an actuator unit.

### Background Art

Conventionally, in this type of actuator used for damping application of a railroad vehicle, an actuator is known that is interposed between a vehicle body and a bogie and used, in order to suppress vibration in the left-right direction with respect to the travel direction of the vehicle body in a railroad vehicle, for example. The actuator includes a motor for driving a pump, and can control the motor with an actuator control device, and adjust driving force generated by the actuator, to suppress vibration of the vehicle body.

The railroad vehicle is driven by receiving power supply from a trolley wire, and a power source supplying power to the trolley wire is an AC power source. When power sources having different phases are connected to the trolley wire directly, inconvenience occurs such as flow of excessive current due to mixed touch between the power sources.

For that reason, a feeding switching section is provided at a switching position of feeding to prevent the mixed touch; however, a dead section not supplied with power is provided at the feeding switching section, and the railroad vehicle cannot receive power supply when passing through the dead section. A relatively high voltage is required for driving an actuator of a railroad vehicle damping device. Within the dead section, a power failure occurs, in which power cannot be supplied to the actuator, and the actuator cannot be driven.

Therefore, the actuator control device, as disclosed in JP 2011-2011332 A, holds position information of the feeding switching section, and grasps a power failure position from a traveling position of the railroad vehicle obtained from a vehicle monitor, and stops rotation of the motor before a power failure to suppress degradation of ride quality.

### Summary of the Invention

### Problems to be Solved by the Invention

However, in the actuator control device, the power failure position cannot be accurately grasped when a deviation occurs in current position information of the railroad vehicle, and a power failure may occur during controlling the actuator. Also, in a case where a pantograph is separated from the trolley wire, a situation occurs in which the actuator cannot be controlled, but it is difficult to grasp a position at which a separation line occurs, and also in such a case, a state occurs in which the actuator cannot be controlled.

Normally, a drive circuit for driving the motor of the actuator is provided with a converter that converts AC current obtained from the trolley wire to DC current, and a capacitor for smoothing the DC current output by the converter.

When the motor continues to be controlled despite the power failure, the motor consumes charges of the capacitor, and when power supply is enabled, a surge is generated in which an inrush current flows into the capacitor. When such a surge is generated, a breaker for protecting the drive circuit and the like is tripped and shuts off the drive circuit from the power source, and it becomes impossible to return to control of the actuator.

That is, the power failure due to passing through the dead section or the separation line is an event inevitable in operation of the railroad vehicle, and there is a problem that the breaker regards the surge generated at that time as a system abnormality and shuts off the drive circuit, and it becomes impossible to return to the control of the actuator.

Therefore, the present invention has been devised to solve the problem, and an object of the present invention is to provide an actuator control device and an actuator unit capable of returning to the control of the actuator even when the power failure occurs.

The actuator control device of the present invention includes a voltage detector that detects a voltage input to the drive circuit that controls the motor for driving the actuator, and a controller that stops the motor when the voltage detected by the voltage detector is equal to or less than a predetermined voltage threshold.

### Brief Description of Drawings

Fig. 1 is a schematic diagram of an actuator unit in an embodiment.
Fig. 2 is a schematic diagram of an actuator in the embodiment.
Fig. 3 is a diagram illustrating a state in which the actuator in the embodiment is interposed between a vehicle body and a bogie of a railroad vehicle.
Fig. 4 is an explanatory diagram of feeding switching in a feeding switching section.

### Description of Embodiments

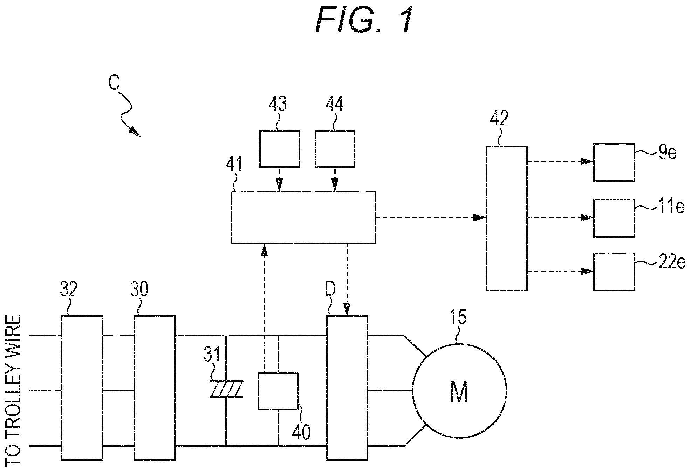

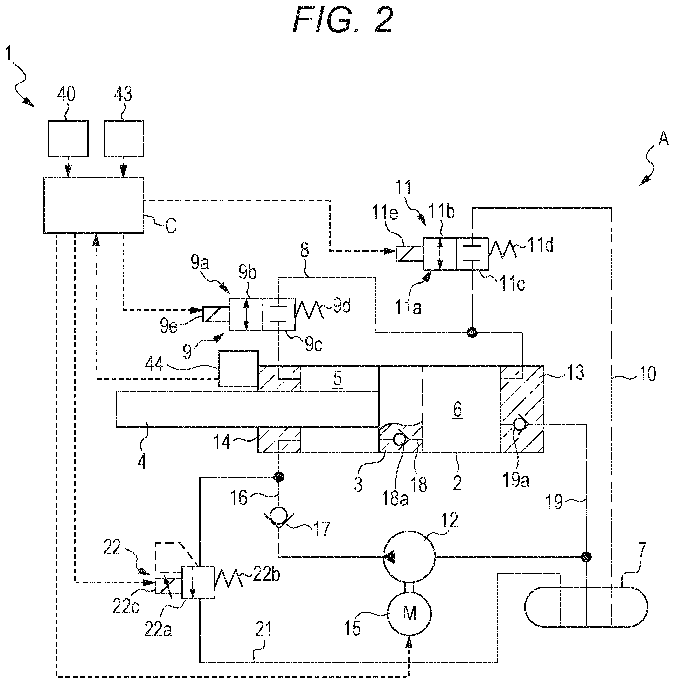

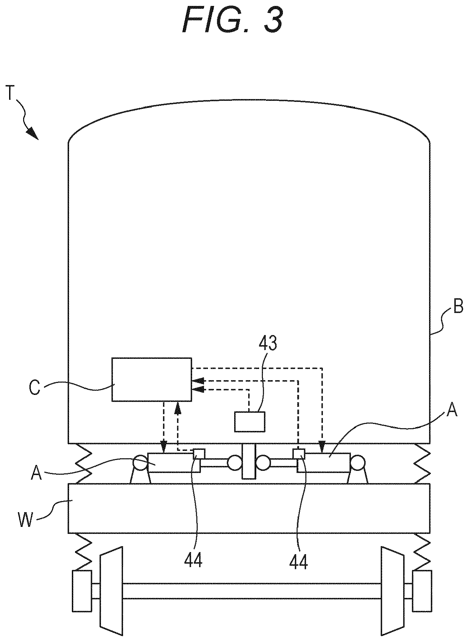

Hereinafter, the present invention will be described with reference to an embodiment illustrated in the drawings. An actuator unit 1 of the embodiment includes an actuator A, and an actuator control device C that controls the actuator A, as illustrated in Figs. 1 and 2. Also, the actuator control device C includes a voltage sensor 40 as a voltage detector that detects a voltage of a current input to a drive circuit D for driving a motor 15, and a controller 41 that controls the drive circuit D. A pair of the actuators A is interposed in parallel between a vehicle body B and a bogie W of a railroad vehicle T, as illustrated in Fig. 3, for example.

The actuator unit 1 suppresses vibration in a horizontal lateral direction with respect to a vehicle travel direction of the vehicle body B with active control, and, for example, performs skyhook control to suppress vibration in the lateral direction of the vehicle body B. Specifically, the actuator unit 1 determines, with the actuator control device C, driving force to be generated by the actuator A from speed in the horizontal lateral direction with respect to the vehicle travel direction of the vehicle body B, and relative speed between the vehicle body B and the bogie W. The controller 41 in the actuator control device C controls driving force of the actuator A in accordance with the driving force determined, to suppress vibration in the lateral direction of the vehicle body B.

First, the actuator A will be described that is a control target of the actuator control device C. The actuator A, as illustrated in Fig. 2, includes a cylinder 2, a piston 3 slidably inserted in the cylinder 2, a rod 4 inserted in the cylinder 2 and coupled with the piston 3, a rod side chamber 5 and a piston side chamber 6 partitioned by the piston 3 in the cylinder 2, a tank 7, a first on-off valve 9 provided in the middle of a first passage 8 causing the rod side chamber 5 and the piston side chamber 6 to communicate with each other, a second on-off valve 11 provided in the middle of a second passage 10 causing the piston side chamber 6 and the tank 7 to communicate with each other, a pump 12 for supplying liquid to the rod side chamber 5, the motor 15 for driving the pump 12, a discharge passage 21 causing the rod side chamber 5 and the tank 7 to communicate with each other, a variable relief valve 22 capable of changing valve opening pressure provided in the discharge passage 21, a rectification passage 18 allowing only flow of liquid from the piston side chamber 6 toward the rod side chamber 5, and a suction passage 19 allowing only flow of liquid from the tank 7 toward the piston side chamber 6, to be configured as a single rod type hydraulic actuator. Also, the rod side chamber 5 and the piston side chamber 6 are filled with liquid such as hydraulic oil, and the tank 7 is filled with the liquid and in addition gas. Incidentally, the interior of the tank 7 is not required to be pressurized by compressing and filling the gas.

The actuator A thus configured is capable of extension drive by bringing the first passage 8 into a communication state by the first on-off valve 9 and driving the pump 12 with the second on-off valve 11 closed. Also, the actuator A is capable of contraction drive by bringing the second passage 10 into a communication state by the second on-off valve 11 and driving the pump 12 with the first on-off valve 9 closed.

Each part of the actuator A will be described in detail. The cylinder 2 is cylindrical, and its right end in Fig. 2 is closed by a lid 13, and an annular rod guide 14 is attached to the left end in Fig. 2. Also, in the rod guide 14, the rod 4 movably inserted in the cylinder 2 is slidably inserted. One end of the rod 4 protrudes to the outside of the cylinder 2, and the other end in the cylinder 2 is coupled with the piston 3 slidably inserted likewise in the cylinder 2.

Incidentally, the space between the outer circumference of the rod 4 and the inner circumference of the rod guide 14 is sealed by a seal member not illustrated, whereby the interior of the cylinder 2 is kept sealed. The rod side chamber 5 and the piston side chamber 6 partitioned by the piston 3 in the cylinder 2 are filled with the hydraulic oil as the liquid as described above.

In a case of the actuator A, the cross-sectional area of the rod 4 is set to one half of the cross-sectional area of the piston 3, and the pressure receiving area of the rod side chamber 5 side of the piston 3 is set to one half of the pressure receiving area of the piston side chamber 6 side. Accordingly, when pressures in the rod side chamber 5 are made to be the same as each other during extension drive and during contraction drive, driving forces generated are equal to each other in both extension and contraction, and flow rates with respect to amounts of displacement of the actuator A are also the same as each other in both extension and contraction sides.

For details, in a case where the actuator A is driven to be extended, the rod side chamber 5 and the piston side chamber 6 communicate with each other, so that pressures in the rod side chamber 5 and the piston side chamber 6 are equal to each other. Accordingly, the actuator A, when being driven to be extended, generates driving force obtained by multiplying together the pressure and a pressure receiving area difference between the rod side chamber 5 side and the piston side chamber 6 side in the piston 3.

On the other hand, in a case where the actuator A is driven to be contracted, communication between the rod side chamber 5 and the piston side chamber 6 is shut off, and the piston side chamber 6 is caused to communicate with the tank 7. For that reason, the actuator A generates driving force obtained by multiplying together the pressure in the rod side chamber 5 and the pressure receiving area of the rod side chamber 5 side in the piston 3. From the above, generated driving force of the actuator A is a value obtained by multiplying together one half of the cross-sectional area of the piston 3 and the pressure in the rod side chamber 5, in both extension and contraction. Therefore, in a case where the driving force of the actuator A is controlled, the pressure in the rod side chamber 5 only needs to be controlled, in both extension drive and contraction drive. Also, since the pressure receiving area of the rod side chamber 5 side of the piston 3 is set to one half of the pressure receiving area of the piston side chamber 6, the pressures in the rod side chamber 5 are the same as each other in the extension side and the contraction side, in a case where the same driving force is generated in both extension and contraction sides, so that control is simplified. Further, flow rates with respect to amounts of displacement of the piston 3 are also the same as each other, so that there is also an advantage that both extension and contraction sides of the actuator A have the same responsiveness. Incidentally, even in a case where the pressure receiving area of the rod side chamber 5 side of the piston 3 is not set to one half of the pressure receiving area of the piston side chamber 6, the point is not changed that the driving forces of both extension and contraction sides of the actuator A can be controlled by the pressure in the rod side chamber 5.

The left end in Fig. 2 of the rod 4 and the lid 13 that closes the right end of the cylinder 2 each include an attachment part not illustrated, and the actuator A can be interposed between the vehicle body B and the bogie W in the railroad vehicle T.

The rod side chamber 5 and the piston side chamber 6 communicate with each other through the first passage 8, and the first on-off valve 9 is provided in the middle of the first passage 8. The first passage 8 causes the rod side chamber 5 and the piston side chamber 6 to communicate with each other outside the cylinder 2, but may be provided in the piston 3.

In a case of the embodiment, the first on-off valve 9 is an electromagnetic on-off valve, and includes: a valve 9a provided with a communication position 9b at which the first passage 8 is opened and the rod side chamber 5 and the piston side chamber 6 communicate with each other, and a shut off position 9c at which communication between the rod side chamber 5 and the piston side chamber 6 is shut off; a spring 9d urging the valve 9a such that the shut off position 9c is taken; and a solenoid 9e that switches the valve 9a to the communication position 9b against the spring 9d during electrification.

The piston side chamber 6 and the tank 7 communicate with each other through the second passage 10, and the second on-off valve 11 is provided in the middle of the second passage 10. In a case of the embodiment, the second on-off valve 11 is an electromagnetic on-off valve, and includes: a valve 11a provided with a communication position 11b at which the second passage 10 is opened and the piston side chamber 6 and the tank 7 communicate with each other, and a shut off position 11c at which communication between the piston side chamber 6 and the tank 7 is shut off; a spring 11d urging the valve 11a such that the shut off position 11c is taken; and a solenoid 11e that switches the valve 11a to the communication position 11b against the spring 11d during electrification.

The pump 12 is driven by the motor 15, and the pump 12 is a pump that discharges liquid in only one direction, and the discharge port communicates with the rod side chamber 5 through a supply passage 16, and the suction port communicates with the tank 7. Accordingly, the pump 12, when driven by the motor 15, suctions the liquid from the tank 7 and supplies the liquid to the rod side chamber 5. The motor 15 receives current supply from the drive circuit D provided in the actuator control device C, to be driven. Regarding power supply to the drive circuit D, as illustrated in Fig. 1, single-phase or three-phase AC current obtained by stepping down the voltage of the trolley wire by a transformer (not illustrated) installed in the railroad vehicle T is converted to DC current by a converter 30, to be supplied.

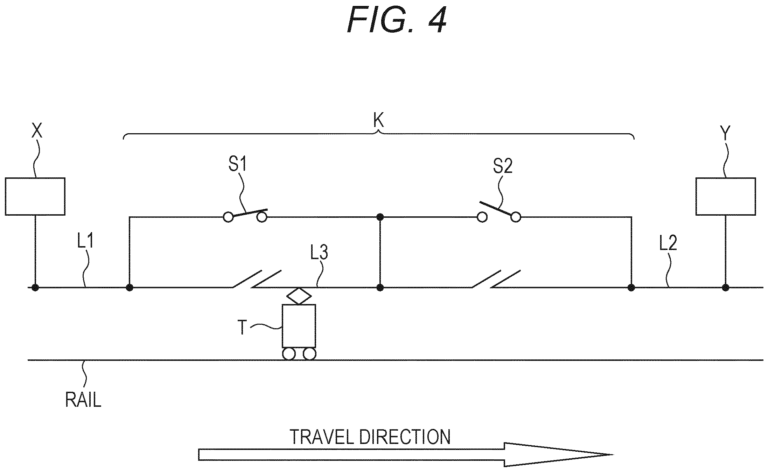

Here, a feeding switching section K will be described. As illustrated in Fig. 4, between a trolley wire L1 connected to a power source X located in a travel direction rear side of the railroad vehicle T and a trolley wire L2 connected to a power source Y located in a travel direction front side of the railroad vehicle T, an intermediate trolley wire L3 is provided that is connected to the trolley wires L1 and L2 via switches S1 and S2. The intermediate trolley wire L3 is basically connected to the power source X located in the travel direction rear side by the switch S1, and when the railroad vehicle T enters a section of the intermediate trolley wire L3, connections between the intermediate trolley wire and both power sources X and Y are temporarily shut off, and then the intermediate trolley wire L3 is connected to the power source Y located in the travel direction front side, and feeding is switched. That is, when the railroad vehicle T passes through the feeding switching section K, the intermediate trolley wire L3 is disconnected from both power sources X and Y, so that time occurs during which a power failure momentarily occurs and power supply cannot be received. As described above, since current supply to the motor 15 is obtained directly from the trolley wires L1 and L2, when a power failure occurs during traveling in the intermediate trolley wire L3 corresponding to the dead section, the current cannot be supplied to the motor 15. In this way, while the railroad vehicle travels in the section of the intermediate trolley wire L3 in the feeding switching section K illustrated in Fig. 4, current supply to the motor 15 is momentarily shut off by feeding switching operation as described above.

As described above, the pump 12 only discharges the liquid in only one direction and has no rotation direction switching operation, so that there is no problem that an amount of discharge changes during rotation switching, and an inexpensive gear pump or the like can be used. Further, since the rotation direction of the pump 12 is always the same direction, high responsiveness to rotation switching is not required in the motor 15 that is a drive source for driving the pump 12, so that an inexpensive motor can be used for the motor 15. Incidentally, in the middle of the supply passage 16, a check valve 17 is provided that prevents reverse flow of the liquid from the rod side chamber 5 to the pump 12.

In the present example, the rod side chamber 5 and the tank 7 are connected to each other through the discharge passage 21, and the variable relief valve 22 capable of changing the valve opening pressure is provided in the middle of the discharge passage 21. The variable relief valve 22 includes a valve body 22a provided in the middle of the discharge passage 21, a spring 22b urging the valve body 22a to shut off the discharge passage 21, and a proportional solenoid 22c that generates driving force against the spring 22b during electrification. In the variable relief valve 22, the valve opening pressure can be adjusted by adjusting an amount of current flowing through the proportional solenoid 22c.

When pressure in the rod side chamber 5 at the upstream side of the discharge passage 21 affecting the valve body 22a exceeds relief pressure (valve opening pressure), the pressure and force of the proportional solenoid 22c pressing the valve body 22a overcome force of the spring 22b urging the valve body 22a against the force. Then, the valve body 22a retreats, and the variable relief valve 22 opens the discharge passage 21.

In the variable relief valve 22, when the amount of current supplied to the proportional solenoid 22c is increased, driving force generated by the proportional solenoid 22c can be increased. Accordingly, when the amount of current supplied to the proportional solenoid 22c is maximized, the valve opening pressure of the variable relief valve 22 is minimized, and on the contrary, when the current is not supplied to the proportional solenoid 22c at all, the valve opening pressure of the variable relief valve 22 is maximized.

Regardless of opening/closing states of the first on-off valve 9 and the second on-off valve 11, when there is an excessive input in extension/contraction directions to the actuator A, and the pressure in the rod side chamber 5 exceeds the valve opening pressure, the variable relief valve 22 opens the discharge passage 21 and causes the rod side chamber 5 to communicate with the tank 7. In this way, for the excessive input to the actuator A, the variable relief valve 22 releases the pressure in the rod side chamber 5 to the tank 7 to protect the entire system of the actuator A.

The piston 3 is provided with the rectification passage 18 causing the piston side chamber 6 and the rod side chamber 5 to communicate with each other, and the rectification passage 18 is provided with a check valve 18a. Accordingly, the rectification passage 18 is set as a one-way passage allowing only the flow of the liquid from the piston side chamber 6 toward the rod side chamber 5. Further, the lid 13 is provided with the suction passage 19 causing the tank 7 and the piston side chamber 6 to communicate with each other, and the suction passage 19 is provided with a check valve 19a. Accordingly, the suction passage 19 is set as a one-way passage allowing only the flow of the liquid from the tank 7 toward the piston side chamber 6. Incidentally, when the shut off position 9c of the first on-off valve 9 is a check valve, the rectification passage 18 can be integrated in the first passage 8, and when the shut off position 11c of the second on-off valve 11 is a check valve, the suction passage 19 can be integrated in the second passage 10.

In a case where the actuator A thus configured is caused to exert desired driving force in the extension direction, while the first on-off valve 9 is caused to take the communication position 9b and the second on-off valve 11 is caused to take the shut off position 11c and the motor 15 is rotated, the liquid is supplied from the pump 12 into the cylinder 2. Thus, the rod side chamber 5 and the piston side chamber 6 are in a communication state and the liquid is supplied from the pump 12 to both chambers, and the piston 3 is pressed to the left in Fig. 2 and the actuator A exerts the driving force in the extension direction. When the pressures in the rod side chamber 5 and the piston side chamber 6 exceed the valve opening pressure of the variable relief valve 22, the variable relief valve 22 is opened and the liquid is released to the tank 7 via the discharge passage 21, and the pressures in the rod side chamber 5 and the piston side chamber 6 are equal to the valve opening pressure of the variable relief valve 22. That is, adjustment of the valve opening pressure of the variable relief valve 22 can cause the actuator A to exert driving force in the extension direction, the driving force being obtained by multiplying together the valve opening pressure of the variable relief valve 22 and the pressure receiving area difference between the piston side chamber 6 side and the rod side chamber 5 side in the piston 3. Incidentally, even when the actuator A is forcibly contracted by external force, the pressures in the rod side chamber 5 and the piston side chamber 6 are controlled to the valve opening pressure of the variable relief valve 22, so that the driving force in the extension direction is exerted that suppresses contraction.

On the other hand, in a case where the actuator A is caused to exert desired driving force in the contraction direction, while the first on-off valve 9 is caused to take the shut off position 9c and the second on-off valve 11 is caused to take the communication position 11b and the motor 15 is rotated, the liquid is supplied from the pump 12 into the rod side chamber 5. Thus, the piston side chamber 6 and the tank 7 are in a communication state and the liquid is supplied from the pump 12 to the rod side chamber 5, and the piston 3 is pressed to the right in Fig. 2 and the actuator A exerts the driving force in the contraction direction. Similarly to the description above, adjustment of the valve opening pressure of the variable relief valve 22 can cause the actuator A to exert driving force in the contraction direction, the driving force being obtained by multiplying together the valve opening pressure of the variable relief valve 22 and the pressure receiving area of the rod side chamber 5 side in the piston 3. Incidentally, even when the actuator A is forcibly extended by external force, the pressure in the rod side chamber 5 is controlled to the valve opening pressure of the variable relief valve 22, so that the driving force in the contraction direction is exerted that suppresses extension.

In the actuator A, when both the first on-off valve 9 and the second on-off valve 11 take the shut off positions 9c and 11c, respectively, in the rectification passage 18, the suction passage 19, and the discharge passage 21, the rod side chamber 5, the piston side chamber 6, and the tank 7 communicate with each other in a row. In this state, regardless of whether the pump 12 is driven or not, when the actuator A is extended or contracted by external force, the pressure in the rod side chamber 5 is controlled to the valve opening pressure of the variable relief valve 22, so that the actuator A functions as a passive damper that exerts driving force suppressing extension and contraction. When current supply is shut off to the motor 15, the first on-off valve 9, the second on-off valve 11, and the variable relief valve 22, the first on-off valve 9 and the second on-off valve 11 take the shut off positions 9c and 11c, respectively, and the variable relief valve 22 functions as a pressure control valve whose valve opening pressure is fixed to the maximum. Accordingly, the actuator A can automatically function as the passive damper when power supply is shut off or during failure.

Incidentally, the actuator A only needs to be capable of being extended and contracted by the motor, and when the actuator A having the above-described configuration is used, there is an advantage that the actuator can automatically function as the passive damper when power cannot be supplied. Also, the actuator A uses the liquid as a working medium in this example, but may use gas as the working medium, and may be an electromagnetic actuator that uses torque of the motor as it is as the driving force.

To control the driving force of the actuator A, as illustrated in Fig. 1, the actuator control device C includes an acceleration sensor 43 that detects acceleration in the horizontal lateral direction of the vehicle body B, a stroke sensor 44 that detects displacement of the actuator A, the controller 41 that controls the actuator A on the basis of information obtained from the sensors, the drive circuit D that supplies current to the motor 15 in accordance with a command from the controller 41, a driver 42 that supplies current to the solenoids 9e, 11e, and 22c of the respective first on-off valve 9, the second on-off valve 11, and the variable relief valve 22 to adjust magnitude of the driving force and an exerting direction of the driving force in the actuator A in accordance with the command from the controller 41, and the voltage sensor 40 that detects the voltage of the current input to the drive circuit D for driving the motor 15.

Regarding power supply to the drive circuit D that supplies current to the motor 15, as described above, single-phase or three-phase AC voltage obtained by stepping down the voltage of the trolley wire by a transformer (not illustrated) installed in the railroad vehicle T is converted to DC voltage by a converter 30, to be supplied.

Incidentally, in a power source side from the converter 30, a breaker 32 is provided that opens wiring between the converter 30 and the power source when excessive current is detected, to prevent the excessive current from flowing to the drive circuit D side.

In a circuit connecting the converter 30 and the drive circuit D to each other, a smoothing capacitor 31 is provided as a smoothing circuit. As the smoothing circuit, a circuit including only a capacitor may be used, and in addition, a choke input type smoothing circuit or a capacitor input type smoothing circuit including a combination of a smoothing capacitor and a coil may be used.

The converter 30, in this case, performs full-wave rectification to convert AC voltage to DC voltage. Regarding the converter 30, a converter that performs half-wave rectification can be used; however, it is efficient to use a converter capable of full-wave rectification.

The voltage sensor 40 detects a voltage of the smoothing capacitor 31 and inputs the voltage to the controller 41. The voltage sensor 40 may detect a voltage in wiring between the converter 30 and the smoothing capacitor 31.

In the present example, the motor 15 is a three-phase brushless motor, and the drive circuit D is an inverter circuit provided with three arms each including a pair of switching devices to supply current to a three-phase winding of the motor 15. Incidentally, the motor 15 may be a motor other than the brushless motor, and a circuit suitable for driving the motor 15 can be used as the drive circuit D.

A driver suitable for driving the solenoids 9e, 11e, and 22c can be used as the driver 42, and the driver includes three switching devices respectively corresponding to the solenoids 9e, 11e, and 22c to be able to supply and stop current to the solenoids 9e, 11e, and 22c.

The controller 41 determines the speed in the lateral direction of the vehicle body B and the relative speed in the lateral direction between the vehicle body B and the bogie W, from the acceleration sensor 43 and the stroke sensor 44, and determines the magnitude and the direction of the driving force to be generated by the actuator A in accordance with the skyhook control law. The controller 41 is capable of on-off control of the switching devices of the drive circuit D and the driver 42 to cause the actuator A to generate the driving force determined as described above.

When the voltage detected by the voltage sensor 40 is a voltage at which it is difficult to drive the motor 15, the controller 41 stops current supply to the motor 15. Specifically, when the voltage detected by the voltage sensor 40 is equal to or less than a predetermined voltage threshold, the controller 41 opens all switching devices of the drive circuit D, to shut off current supply from power source side to the motor 15. The voltage threshold is set in accordance with the rating of the motor 15, and is set to about a voltage at which torque and rotation speed required for driving the actuator A cannot be obtained.

Incidentally, although not illustrated, as a hardware resource, specifically, the actuator control device C only needs to include: an A/D converter for taking in signals output by the voltage sensor 40, the acceleration sensor 43, and the stroke sensor 44; a D/A converter for outputting signals to the switching devices in the drive circuit D and the driver 42; a storage device such as read only memory (ROM) that stores a program used for processing required for control of the actuator A; a calculation device such as a central processing unit (CPU) that executes processing based on the program; and a storage device such as random access memory (RAM) that provides a storage area to the CPU, for example. The CPU executes the program, whereby control operation of the actuator control device C is realized.

The actuator unit 1 is configured as described above, and operation of the actuator unit 1 will be described below. First, a case will be described where the railroad vehicle T travels in a section other than the feeding switching section K. In this case, the actuator control device C performs active control to the actuator A, to suppress vibration affecting the vehicle body B of the railroad vehicle T.

As described above, the actuator control device C determines the driving force required for suppressing vibration of the vehicle body B, and controls the motor 15, the first on-off valve 9, the second on-off valve 11, and the variable relief valve 22 through the drive circuit D and the driver 42 to cause the actuator A to exert the driving force determined.

As described above, in a case where the actuator A is caused to exert the driving force in the extension direction, while the first on-off valve 9 is caused to take the communication position 9b and the second on-off valve 11 is caused to take the shut off position 11c and the motor 15 is rotated, the liquid is supplied from the pump 12 into the cylinder 2. On the other hand, in a case where the actuator A is caused to exert the driving force in the contraction direction, while the first on-off valve 9 is caused to take the shut off position 9c and the second on-off valve 11 is caused to take the communication position 11b and the motor 15 is rotated, the liquid is supplied from the pump 12 into the rod side chamber 5.

In this way, normally, the actuator control device C continuously performs control that determines the driving force to be generated by the actuator A, and rotates the motor 15 to cause the actuator A to exert the driving force, except for control of when the railroad vehicle T passes through the dead section. Thus, active control is performed to the driving force of the actuator A by the actuator control device C, and vibration of the vehicle body B is effectively suppressed.

When the railroad vehicle T passes through the dead section in the feeding switching section K, stop determination of the motor 15 is made as follows, and current supply to the motor 15 is stopped.

When the railroad vehicle T passes through the intermediate trolley wire L3 that is the dead section in the feeding switching section K and a power failure occurs, when the motor 15 is electrified and the driving force of the actuator A continues to be controlled, the voltage detected by the voltage sensor 40 decreases due to discharge of the smoothing capacitor 31. Due to this voltage decrease, when the voltage detected by the voltage sensor 40 is equal to or less than the predetermined voltage threshold, the controller 41 stops current supply from the drive circuit D to the motor 15. Then, discharge from the smoothing capacitor 31 also stops, and the voltage of the smoothing capacitor 31 becomes a voltage equal to or less than the predetermined voltage threshold and close to the predetermined voltage threshold, and is not stepped down lower than that. Even when the railroad vehicle T is connected to the trolley wire L2 connected to the power source Y and power supply is restarted in this situation, a potential difference is small between the voltage of the smoothing capacitor 31 and the voltage of the power source side, so that surge is not generated, and the breaker 32 is not tripped. Accordingly, with the actuator control device C, even when the railroad vehicle T passes through the dead section, or is separated from the trolley wires L1-L3 and a power failure occurs, generation of surge is suppressed and the breaker 32 is prevented to be tripped, so that the actuator A does not become uncontrollable when returning from the power failure to a state in which power can be supplied. That is, it is possible to prevent that the breaker 32 erroneously detects a system abnormality due to the power failure caused by passing through the dead section or the separation line.

When the predetermined voltage threshold is set depending on the torque and the rotation speed required for the motor 15 to drive the actuator A, current supply to the motor 15 can be stopped when it is difficult to drive the actuator A with the motor 15, and a useless voltage drop of the smoothing capacitor 31 can be avoided.

Incidentally, to the trolley wires L1 and L2, power sources not illustrated are connected, and AC voltages are applied, and the voltages of the trolley wires L1 and L2 may fluctuate along with fluctuation of the voltages output by the power sources. When the predetermined voltage threshold is set to a lower value than a voltage fluctuation value of the same trolley wire L1 (L2), the voltage detected by the voltage sensor 40 does not become a voltage equal to or less than the predetermined voltage threshold, depending on voltage fluctuation of the trolley wire L1 (L2). Accordingly, when the predetermined voltage threshold is set to the lower value than the voltage fluctuation value of the same trolley wire L1 (L2), it can be prevented that current supply to the motor 15 is stopped due to the voltage fluctuation of the trolley wire L1 (L2). That is, when the predetermined voltage threshold is set to the lower value than the voltage fluctuation value of the same trolley wire L1 (L2), it can be avoided that current supply to the motor 15 is stopped due to erroneous detection of the power failure.

The actuator control device C is not required to grasp whether or not a traveling position of the railroad vehicle T is within the dead section, so that it is possible not only to cope with the power failure due to the separation line, but also to apply to a railroad vehicle for which acquisition of correct traveling position information or acquisition of traveling position information itself is impossible. In addition, it is not required to grasp whether or not the traveling position of the railroad vehicle T is within the dead section, so that a calculation processing load of the controller 41 is reduced, and it is possible to use a processor with a lower calculation processing capacity and reduce the cost.

Incidentally, current supply via the driver 42 to the solenoid 9e of the first on-off valve 9, the solenoid 11e of the second on-off valve 11, and the proportional solenoid 22c of the variable relief valve 22, is a separate system from current supply to the motor 15. Accordingly, even in the power failure during passing through the feeding switching section K, it is possible to receive current supply from an electric condenser in the railroad vehicle T, and the actuator control device C can control devices of the actuator A excluding the motor 15.

While the motor 15 is stopped, the actuator control device C determines the driving force required for suppressing vibration of the vehicle body B from the displacement of the actuator A and the lateral acceleration of the vehicle body B sequentially sampled. The actuator control device C controls the first on-off valve 9, the second on-off valve 11, and the variable relief valve 22 on the basis of the driving force determined, and performs skyhook control to cause the actuator A to function as a semi-active damper. Calculation of the driving force is obtained, in particular, by performing a calculation similar to calculation during normal control when the motor 15 is rotated. In this way, also during passing through the feeding switching section K in which there is no liquid supply from the pump 12, the actuator A is caused to function as the semi-active damper, so that vibration suppression of the vehicle body B can be continued continuously.

In this way, the actuator A in the actuator unit 1 in the present example functions as the semi-active damper by electrifying the first on-off valve 9, the second on-off valve 11, and the variable relief valve 22 even when the motor 15 is stopped. Accordingly, even when the voltage detected by the voltage sensor 40 is equal to or less than the predetermined voltage threshold and driving of the motor 15 is stopped, the actuator A is caused to function as the semi-active damper, and vibration suppression of the vehicle body B is continuously performed also during the power failure. Also, during returning, the actuator A can exert the function as an actuator capable of generating the driving force positively from the semi-active damper, so that a vibration suppression function is continuously exerted during passing through the dead section, and ride quality in the railroad vehicle T can be improved. Also, even when power cannot be supplied to the actuator A at all, the actuator A automatically functions as the passive damper, so that a vibration suppression effect is not lost, and degradation of the ride quality of the railroad vehicle T can be suppressed.

The voltage sensor 40 does not detect a voltage of an AC power source side, but detects a voltage between the drive circuit D and the converter 30 that converts AC current to DC current, so that determination to stop current supply to the motor 15 can be performed in a timely manner by only comparison with the voltage threshold. To determine stop of current supply to the motor 15, it is sufficient to detect that power is not supplied from the trolley wire. Therefore, the power failure can also be detected by a method in which the voltage sensor 40 is provided in the power source side from the converter 30, and the maximum crest value of the voltage detected by the voltage sensor 40 is compared with the voltage threshold. However, in this case, since it takes time for determination up to motor stop, and in addition, a device is required for signal processing, it is advantageous to detect the voltage between the converter 30 and the drive circuit D by the voltage sensor 40.

In the present example, the voltage sensor 40 detects a voltage smoothed by the smoothing capacitor 31 provided between the converter 30 and the drive circuit D. In this way, the voltage detected by the voltage sensor 40 is a voltage from which ripples are removed, and is a voltage to be applied to the drive circuit D, so that motor stop determination can be more accurately performed.

The present application claims priority based on Japanese Patent Application No. 2015-140969 filed on July 15, 2015 in the Japan Patent Office, the entire contents of which are incorporated herein by reference.

## Claims

1. An actuator control device comprising:
a drive circuit that controls a motor for driving an actuator interposed between a vehicle body and a bogie of a railroad vehicle;
a voltage detector that detects a voltage input to the drive circuit; and
a controller that stops the motor when the voltage detected by the voltage detector is equal to or less than a predetermined voltage threshold.

2. The actuator control device according to claim 1, wherein
the voltage threshold is set depending on torque and rotation speed required for the motor to drive the actuator.

3. The actuator control device according to claim 1, wherein
the railroad vehicle is supplied with power from a trolley wire, and
the voltage threshold is set to a value lower than a voltage fluctuation value of the same trolley wire.

4. The actuator control device according to claim 1, wherein
the voltage detector detects a voltage between the drive circuit and a converter that converts AC current to DC current.

5. The actuator control device according to claim 4, wherein
the voltage detector detects a voltage smoothed by a smoothing circuit provided between the drive circuit and the converter.

6. An actuator unit comprising:
an actuator control device according to claim 1; and
an actuator including a cylinder, a piston slidably inserted in the cylinder, a rod inserted in the cylinder and coupled with the piston, a rod side chamber and a piston side chamber partitioned by the piston in the cylinder, a tank, a first on-off valve provided in a first passage causing the rod side chamber and the piston side chamber to communicate with each other, a second on-off valve provided in a second passage causing the piston side chamber and the tank to communicate with each other, a pump for supplying liquid to the rod side chamber, the motor for driving the pump, a discharge passage causing the rod side chamber and the tank to communicate with each other, a variable relief valve capable of changing valve opening pressure provided in the discharge passage, a rectification passage allowing only flow of liquid from the piston side chamber toward the rod side chamber, and a suction passage allowing only flow of liquid from the tank toward the piston side chamber.
